# EUROPEAN PATENT APPLICATION

(11) **EP 1 132 198 A1**
(43) Date of publication of application: **12.09.2001**
(21) Application number: 00111754.8
(22) Date of filing: 02.06.2000
(51) Int. Cl.: B32B 27/32, C23C 16/40

(54) **Gas barrier film having polypropylene as a base film and method of manufacturing the same**

(30) Priority: 06.03.2000 JP 2000060288
(71) Applicant: President of Shizuoka University, Shizuoka-shi, Shizuoka-ken (JP)
(72) Inventor: Inagaki, Norihiro, Hamamatsu-shi, Shizuoka-ken (JP); Tasaka, Shigeru, Shizuoka-shi, Shizuoka-ken (JP); Nakajima, Tetsuya, Hamamatsu-shi, Shizuoka-ken (JP)
(74) Representative: Hertz, Oliver, Dr.

(57) **Abstract**

There is disclosed a gas barrier film having, as a base film, a polypropylene film, which makes it possible to take advantage of the excellent gas barrier property inherent to an SiOₓ thin film formed on the polypropylene film, and which is free from chlorine which would give a bad influence to the environment. This gas barrier film comprises a polypropylene film whose surface is bonded with tuning molecular chains having, as a main skeleton, an -O-Si-O- structure by enabling the oxygen (-0-) thereof to be bonded to carbon atoms of the surface of the polypropylene film, and an SiOₓ thin film formed on the surface of the polypropylene film where the tuning molecular chains are bonded, the SiOₓ thin film being bonded to the tuning molecular chains interposed between the polypropylene film and the SiOₓ thin film.

## Description

This invention relates to a gas barrier film having polypropylene as a base film, which is adapted to be used as a packing material for various foodstuffs and other products, and also to a method of manufacturing such a gas barrier film.

Since plastic films such as polyethylene terephthalate (PET) and polypropylene (PP) for instance are inherently poor in barrier properties against oxygen and water vapor, these films are additionally provided with a vapor deposition of aluminum foil or a coating of polyvinylidene chloride for providing these films with enhanced barrier properties against oxygen and water vapor if these films are to be employed as a packing material. For example, a laminate film provided with a coating of polyvinylidene chloride is now available in the market as a K-coat film (trade name).

Such a laminate film enhanced with barrier properties is now produced in a vast quantity of 47.6 trillions square meters per year in Japan as a packing material for foodstuffs. Especially, a laminate film provided with a vapor deposition of aluminum foil occupies about 44% of the entire packing material, making it a leading product in the gas barrier films at present.

However, since it is difficult to recycle aluminum foil due to the manner of employment thereof, the employment of aluminum foil is not preferable in viewpoint of effective utilization or preservation of earth resources. On the other hand, since polyvinylidene chloride gives rise to the generation of dioxin as it is incinerated, the employment of polyvinylidene chloride is not preferable in viewpoint of environmental sanitation. Under such circumstances, it is now intensively studied to develop a new gas barrier material substituting for these aluminum foil and polyvinylidene chloride.

As one of the results of such studies, there has been developed a laminate film comprising a plastic film of any kind and a gas barrier film consisting a silicon oxide (SiOₓ) thin film which is free from the generation of any harmful gas as it is incinerated. This laminate film is now being tried to use as a packing material. For example, when a PET film is employed as a plastic film in this laminate film, the gas barrier properties of aforementioned SiOₓ thin film can be effectively utilized, thus making it possible to utilize this laminate film as a packing material.

On the other hand, it has been also tried to vapor-deposit the aforementioned SiOₓ thin film on the surface of PP film (especially, an orientated polypropylene film; OPP film), which is less expensive than the PET film. However, this laminate film is accompanied with a problem that a crack tends to be generated in the SiOₓ thin film on the occasion of vapor deposition thereof, thereby making it difficult to make the most of the excellent gas barrier properties of the SiOₓ thin film.

Therefore, an object of the present invention is to provide a gas barrier film having, as a base film, a PP film which enables an excellent gas barrier SiOₓ thin film to be formed thereon, and containing no chlorine which would give a bad influence to the environment as in the case of the K-coat film.

Another object of the present invention is to provide a method of manufacturing such a gas barrier film.

Namely, according to this invention, there is provided a gas barrier film which comprises;
a polypropylene film whose surface is bonded with tuning molecular chains having, as a main skeleton, an -O-Si-O- structure by enabling the oxygen (-O-) thereof to be bonded to carbon atoms of the surface of the polypropylene film; and
an SiOₓ thin film formed on the surface of the polypropylene film where the tuning molecular chains are bonded, the SiOₓ thin film being bonded to the tuning molecular chains interposed between the polypropylene film and the SiOₓ thin film.

There is also provided a method of manufacturing a gas barrier film having polypropylene as a base film, the method comprising the steps of;
activating carbon atoms of a surface of the polypropylene film by subjecting the polypropylene film to a plasma treatment, the activated carbon atoms being subsequently exposed to air atmosphere to allow the activated carbon atoms to be bonded with oxygen, thereby introducing oxygen functional groups into the surface of the polypropylene film;
allowing a coupling reaction to take place between the oxygen functional group of the polypropylene film and a silane coupling agent, thereby bonding tuning molecular chains having, as a main skeleton, an -O-Si-O- structure, to carbon atoms of the surface of the polypropylene film through the oxygen functional group (-O-); and
allowing a plasma polymerization between Si and O in a plasma atmosphere containing an organic silane compound and oxygen, thereby forming an SiOₓ thin film on the surface of the polypropylene film having the tuning molecular chains bonded therein.

This summary of the invention does not necessarily describe all necessary features so that the invention may also be a sub-combination of these described features.

The invention can be more fully understood from the following detailed description when taken in conjunction with the accompanying drawings, in which:

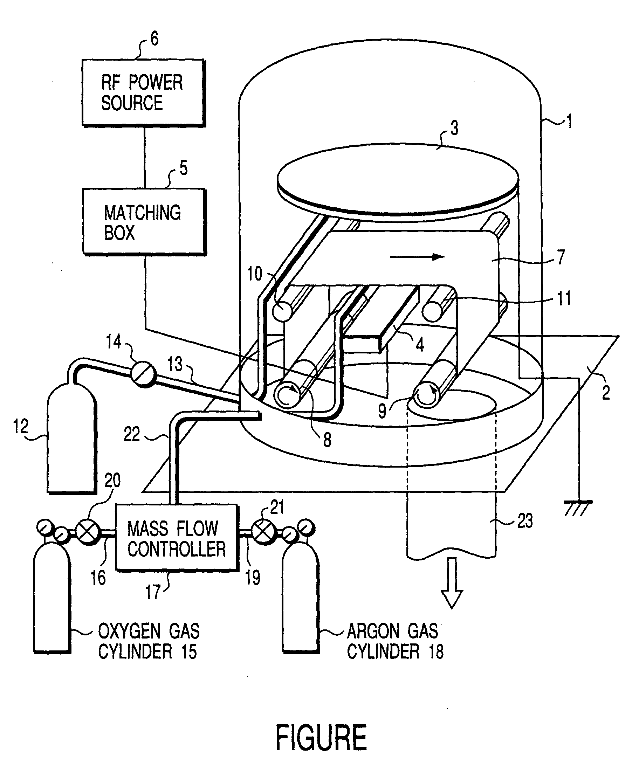

The single figure is a perspective view showing a plasma polymerization apparatus (which also functions as a plasma treatment apparatus) to be employed in the examples of this invention.

Next, this invention will be explained in detail as follows.

The gas barrier film whose base film is composed of polypropylene according to this invention comprises a polypropylene film whose surface is bonded with a tuning molecular chains having, as a main skeleton, an -O-Si-O- structure by enabling the oxygen (-O-) thereof to be bonded to carbon atoms of the surface of the polypropylene film; and an SiOₓ thin film formed on the surface of the polypropylene film where the tuning molecular chains are bonded; the SiOₓ thin film being bonded to the tuning molecular chains interposed between the polypropylene film and the SiOₓ thin film.

As for the polypropylene (PP) film to be employed herein, it is possible to employ a non-orientated film, or a uniaxially or biaxially oriented film (OPP film) for instance.

The thickness of the PP film should preferably be in the range of 10 to 50 *µ*m.

The phrase "tuning molecular chain" employed herein means either a straight chain structure having, as a main skeleton, an -O-Si-O- structure (in this case, a couple of functional groups selected from hydrogen, oxygen and alkyl group are bonded to this Si), wherein the oxygen group (-O-) positioning at one terminal of the main skeleton is bonded to the carbon atom of the PP film, while the oxygen group (-O-) positioning at the other terminal of the main skeleton is provided with hydrogen atom or an alkyl group; or a network structure wherein the Si in one -O-Si-O- structure is bonded to the Si in another -O-Si-O- structure via the oxygen group (-O-) thereof. In this case, the alkyl group bonded to the Si should preferably be selected from those having 1 to 4 carbon atoms.

The introduction ratio of the tuning molecular chains to the polypropylene film should preferably be in the range of 0.05 to 0.20 as measured based on an atomic ratio between the total number of carbon atoms constituting the surface of the PP film and the number of oxygen atoms (oxygen functional groups), each partially bonded to a carbon atom (i.e. Q_{O}/Q_{C}; wherein Q_{C} represents the total number of carbon atoms constituting the surface of the PP film, and Q_{O} is the number of oxygen functional groups, each partially bonded to a carbon atom). If this atomic ratio Q_{O}/Q_{C} is less than 0.05, it may become difficult, due to an insufficient introduction quantity of the tuning molecular chains, to effectively utilize the tuning molecular chains as a buffering material for the PP film as well as for the SiOₓ thin film, and to sufficiently enhance the bonding strength of the SiOₓ thin film to the PP film. On the other hand, if this atomic ratio Q_{O}/Q_{C} is more than 0.20, the inherent properties (such as tensile strength) of the PP film may be deteriorated due to an excessive introduction quantity of the tuning molecular chain.

The expression of: "the SiOₓ thin film being bonded to the tuning molecular chains interposed between the polypropylene film and the SiOₓ thin film" employed herein means that at least one of Si and O constituting the SiOₓ thin film is entirely or partially bonded to the main skeleton of the tuning molecular chains.

Preferably, the thickness of the SiOₓ thin film should be 100 nm or more.

Next, the method of manufacturing a gas barrier film having polypropylene as a base film according to this invention will be explained.

### (First step)

First of all, the carbon atoms existing in the surface region of a PP film is subjected to a plasma treatment so as to activate the carbon atoms, and then, the activated carbon atoms are exposed to air atmosphere to allow the activated carbon atoms to be bonded with oxygen, thereby introducing oxygen functional groups into the surface of the PP film. This introduction of oxygen functional groups can be detected by making use of an XPS spectral analyzer.

As for the polypropylene (PP) film to be employed herein, it is possible to employ a non-orientated film, or a uniaxially or biaxially oriented film (OPP film) for instance. The thickness of the PP film should preferably be in the range of 10 to 50 *µ*m.

The plasma treatment should preferably be performed by making use of an argon plasma (argon atmosphere). By the way, when the PP film is subjected to a plasma treatment using a gas atmosphere containing a relatively large quantity of oxygen, the oxidizing reaction of PP becomes violent, thereby greatly damaging the surface of the PP film, thus deteriorating the inherent properties of the PP film.

Preferably, the plasma treatment should be performed using a DC or high-frequency (up to 24 GHz) power source and under the conditions of 25 to 500W in output, 0.03 to 3 Torr in in-chamber pressure, 1 to 10 cc/min in gas flow rate, and 5 seconds to 3 minutes in treatment time.

The oxygen functional groups can be introduced, via the carbon atoms of the PP film, into the surface of the PP film in the form of C-O and/or C=O. The introduction ratio of this oxygen functional groups to the PP film should preferably be in the range of 0.05 to 0.20 as measured based on an atomic ratio between the total number of carbon atoms constituting the surface of the PP film and the number of oxygen atoms (oxygen functional groups), each partially bonded to a carbon atom (i.e. Q_{O}/Q_{C}; wherein Q_{C} represents the total number of carbon atoms constituting the surface of the PP film, and Q_{O} is the number of oxygen functional groups, each partially bonded to a carbon atom).

### (Second step)

Then, a silane coupling agent is contacted with the PP film, thereby allowing a coupling reaction to take place between the oxygen functional group of the PP film and the silane coupling agent. In the coupling reaction, tuning molecular chains having, as a main skeleton, an -O-Si-O- structure are bounded to carbon atoms of the surface of the polypropylene film through the aforementioned oxygen functional group (-O-).

As for the silane coupling agent useful in this case, it is possible to employ an organic silane compound represented for example by a general formula of: -(R¹O)ₙ-Si-R²₍₄₋ₙ₎ (wherein R¹ and R² individually represents alkyl group having 1 to 4 carbon atoms). Among the silane coupling agents represented by the aforementioned general formula, an organic silane compound exhibiting a high vapor pressure such as tetramethoxy silane and tetraethoxy silane is more preferable.

Preferably, this coupling reaction should be performed by a process wherein the PP film having the aforementioned oxygen functional group introduced therein is immersed in an alcohol solution of the silane coupling agent, and then, heated in the alcohol solution.

As for the alcohol to be employed in this coupling reaction, although there is not any particular limitation, the employment of methanol or ethanol exhibiting a higher vapor pressure is more preferable.

The concentration of the silane coupling agent in an alcohol solution thereof in this coupling reaction should preferably be in the range of 0.1 to 10% by weight. If the concentration of the silane coupling agent in an alcohol solution thereof is less than 0.1% by weight, it may become difficult to allow the coupling reaction to sufficiently take place. On the other hand, if the concentration of the silane coupling agent in an alcohol solution thereof exceeds over 10% by weight, a condensation reaction may take place through the mutual reaction of silane coupling agent in addition to the coupling reaction between the oxygen functional group introduced into the surface of the PP film and the silane coupling agent, thereby generating unwanted substances on the surface of the PP film.

The heating temperature in this coupling reaction should preferably be controlled within the range of 50 to 80°C.

### (Third step)

Then, a plasma polymerization is allowed to take place between Si and O chains bonded in a plasma atmosphere containing an organic silane compound and oxygen, thereby forming an SiOₓ thin film on the surface of PP film having the tuning molecular chains bonded therein to obtain a gas barrier film having PP as a base film.

As for the organic silane compound useful in this case, it is possible to employ those represented for example by a general formula of: -(R¹O)ₙ-Si-R²₍₄₋ₙ₎ (wherein R¹ and R² individually represents alkyl group having 1 to 4 carbon atoms). Among the organic silane compounds represented by the aforementioned general formula, tetramethoxy silane exhibiting a high vapor pressure is more preferable.

With respect to the organic silane compound and oxygen, they should preferably be employed by mixing them at a molar ratio of; organic silane compound:oxygen = 3:7 - 5:5. If the mixing ratio between the organic silane compound and oxygen falls outside the aforementioned range, it may become difficult to form an SiOₓ thin film which is excellent in gas barrier property and in adhesivity to the PP film.

Preferably, the plasma polymerization should be performed using a DC or high-frequency (up to 24 GHz) power source and under the conditions of 25 to 500W in output, 0.03 to 3 Torr in in-chamber pressure, and 1 to 30 cc/min in mixed gas flow rate.

As explained above, the gas barrier film having PP as a base film according to this invention is featured in that it comprises a polypropylene film whose surface is bonded with tuning molecular chains having, as a main skeleton, an -O-Si-O- structure by enabling the oxygen (-O-) thereof to be bonded to carbon atoms of the surface of the polypropylene film; and an SiOₓ thin film formed on the surface of the polypropylene film where the tuning molecular chains are bonded, the SiOₓ thin film being bonded to the tuning molecular chains interposed between the polypropylene film and the SiOₓ thin film.

Since a tuning molecular chains having, as a main skeleton, an -O-Si-O- structure that has been bonded to the carbon atoms of the surface of the PP film is interposed at an interface between the PP film and the SiOₓ thin film, a difference in mechanical property such as thermal expansion coefficient between the PP film and the SiOₓ thin film can be alleviated. As a result, it is now possible to inhibit or prevent the SiOₓ thin film from being cracked due to such a difference in mechanical property between these films. Therefore, it is now possible to effectively take advantage of the excellent gas barrier property of the SiOₓ thin film.

Additionally, due to the presence of the tuning molecular chains, the SiOₓ thin film is enabled to closely adhere to the PP film. Namely, the SiOₓ thin film is not only enabled to strongly adhere to the PP film, but also enabled to adhere to the PP film without generating a void where oxygen can pass through at the interface between the PP film and the SiOₓ thin film. Therefore, it is possible to modify the SiOₓ thin film portion disposed neighboring the PP film, and at the same time, to minimize the mobility of gas such as oxygen at this interface portion.

In particular, when the bond ratio of the tuning molecular chains to the PP film is set to the range of 0.05 to 0.20 as measured based on an atomic ratio between the total number of carbon atoms constituting the surface of the PP film and the number of oxygen atoms (oxygen functional groups), each partially bonded to a carbon atom (i.e. Q_{O}/Q_{C}; wherein Q_{C} represents the total number of carbon atoms constituting the surface of the PP film, and Q_{O} is the number of oxygen functional groups, each partially bonded to a carbon atom), it becomes possible not only to effectively prevent the SiOₓ thin film from being cracked, but also to improve the adherence of the SiOₓ thin film to the PP film.

Therefore, it is now possible not only to effectively take advantage of the excellent gas barrier property of the SiOₓ thin film, but also to modify the SiOₓ thin film portion disposed neighboring the PP film, and at the same time, to minimize the mobility of gas such as oxygen at this interface portion. Therefore, it is now possible to provide a gas barrier film of excellent gas barrier property, which has, as a base film, an inexpensive PP film as compared with a PET film, and is suited for use as a material for packaging various foodstuffs.

Since the gas barrier film according to the present invention is free from chlorine which would give a bad influence to the environment as in the case of the K-coat film having a polyvinylidene chloride coating, the gas barrier film is gentle and unharmful to the environment even if it is scrapped and burned.

The method of manufacturing a gas barrier film having PP as a base film according to this invention is featured in that it comprises the steps of; activating carbon atoms of a surface of the PP base film by subjecting the PP base film to a plasma treatment, the activated carbon atoms being subsequently exposed to air atmosphere to allow the activated carbon atoms to be bonded with oxygen, thereby introducing oxygen functional groups into the surface of the PP base film; allowing a coupling reaction to take place between the oxygen functional group of the PP base film and a silane coupling agent, thereby bonding tuning molecular chains having, as a main skeleton, an -O-Si-O- structure, to carbon atoms of the surface of the PP base film through the oxygen functional group (-O-); and allowing a plasma polymerization between Si and O in a plasma atmosphere containing an organic silane compound and oxygen, thereby forming an SiOₓ thin film on the surface of the PP base film having the tuning molecular chains bonded therein.

According to the aforementioned method of this invention, it is possible to easily manufacture a gas barrier film of excellent gas barrier property, while enabling it to prevent the SiOₓ thin film from being cracked during the deposition of the thin film, to effectively take advantage of the excellent gas barrier property of the SiOₓ thin film, to modify the SiOₓ thin film portion disposed neighboring the PP film, and to minimize the mobility of gas such as oxygen at this interface portion.

Next, preferable examples of this invention will be explained in detail with reference to FIGURE.

This FIGURE represents a perspective view showing a plasma polymerization apparatus (which also functions as a plasma treatment apparatus) employed in the examples of this invention as well as in the comparative example.

The reference numeral 1 in FIGURE denotes a bell-jar type reaction chamber with a dimention 40 mm diameter and 590 mm height, and provided at the underside thereof with a shielding plate 2. Inside this reaction chamber 1, there are disposed a circular electrode (an upper electrode) 3 with a dimention of 380 mm diameter and made of stainless steel for instance and a rectangular electrode (a lower electrode) 4 with a dimention of 50 mm wide and 100 mm long and made of stainless steel for instance, which are separated up and down with a 60 mm gap interposed therebetween. The circular electrode 3 is grounded, while the rectangular electrode 4 is connected via a matching box 5 with a high-frequency power source (RF power source) 6 for instance.

A supply roller 8 having a lengthy OPP film 7 wound thereon and a take-up roller 9 for winding up a treated lengthy OPP film 7 that has been fed from the supply roller 8 are also disposed inside the chamber 1. The chamber 1 is also provided therein with a pair of feed rollers 10 and 11 for feeding the lengthy OPP film 7 from the supply roller 8 to the take-up roller 9 after allowing the lengthy OPP film 7 to pass through a space between the aforementioned electrodes 3 and 4.

A receiver tank 12 filled with a solution of an organic silane compound such as tetramethoxy silane (TMOS) is arranged next to the chamber 1. The steam of TMOS filled in the receiver tank 12 is fed into the chamber 1 through a first gas-feeding pipe 13, the distal end of which has been positioned close to the underside of the electrode 3. The valve 14 is disposed at an intermediate portion of the first gas-feeding pipe 13 which is placed outside the chamber 1. By the way, the TMOS filled in the receiver tank 12 is subjected to a repeated refrigerating operation so as to remove the air dissolved in the TMOS. When the receiver tank 12 is set in place in a temperature controlling oven and kept at a temperature of 60°C, the vapor pressure of the TMOS can be increased, thereby enabling the steam of TMOS to be fed to the interior of chamber 1.

An oxygen gas cylinder 15 is connected via a pipe 16 with a mass flow controller 17. An argon gas cylinder 18 is also connected via a pipe 19 with the mass flow controller 17. These pipes 16 and 19 are provided with valves 20 and 21, respectively. Oxygen or argon that has been fed to the mass flow controller 17 is then fed to the interior of chamber 1 through a second gas-feeding pipe 22, a distal end of which being interposed between the electrodes 3 and 4.

Further, an exhaust pipe 23 is connected with the shielding plate 2 attached to the underside of the chamber 1, the remote end of the exhaust pipe 23 being connected with an exhaust system (not shown) consisting of a rotary pump (displacement: 320 L/min) and a diffusion pump (displacement: 550 L/sec). By the way, a detector (not shown) for detecting the thickness of the SiOₓ thin film deposited on the surface of the lengthy OPP film 7 is placed inside the chamber 1.

### (Example 1)

First of all, a lengthy OPP film (U-10P#, trade name; Tosero Co., Ltd.) having a thickness of 40 *µ*m and a width of 110 mm was wound around a supply roller after the surface of the OPP film was washed in advance with acetone. Then, this supply roller was set in place in the interior of chamber 1 as shown in FIGURE, the distal end portion of the OPP film was pulled, while being guided by a pair of feed rollers 10 and 11, to pass through a space between a pair of electrodes 3 and 4 so as to be wound around the take-up roller 9. Thereafter, the valve 21 attached to the pipe 19 was opened to allow argon to be fed from the argon gas cylinder 18 to the mass flow controller 17, from which a predetermined amount of argon was fed via the second gas-feeding pipe 22 to a space between the electrodes 3 and 4 disposed inside the chamber 1. At the same time, an exhaust system (not shown) consisting of a rotary pump and a diffusion pump was actuated so as to discharge the gas from the chamber 1 via the exhaust pipe 23, thereby reducing the internal pressure of the chamber 1 to 33.9 Pa. Then, a high-frequency power 13.56 MHz in frequency and 60W in output was fed from the RF power source 6 via the matching box 5 to the rectangular electrode (a lower electrode) 4, thereby causing an argon plasma to generate at a space between the electrodes 3 and 4.

Upon confirming the stabilization of the argon plasma at a space between the electrodes 3 and 4 in this operation, the take-up roller 9 was rotated so as to unwind the OPP film 7 from the supply roller 8 and to enable the OPP film 7 to pass, while being guided by a pair of feed rollers 10 and 11, through the argon plasma region formed between the electrodes 3 and 4, thereby subjecting the surface of the OPP film to argon plasma treatment. On this occasion, the running velocity of the OPP film 7 was set to such that the surface of the OPP film 7 could be exposed to the argon plasma for 180 seconds. After finishing the plasma treatment of all of the OPP film 7 that had been wound around the supply roller, the take-up roller 9 was taken out of the chamber 1. When this argon plasma-treated OPP film was taken out of the chamber 1 and hence, exposed to air atmosphere, the activated carbon atoms of the surface of the OPP film was allowed to react with oxygen in the air atmosphere, thereby realizing the introduction of the oxygen functional groups in the forms of C-O and/or C=O. The amount of the oxygen functional groups that had been partially introduced (bonded) to the carbon atoms of the surface of OPP film was measured using an XPS spectral analyzer (ESCA K1; trade name, Shimazu Co., Ltd.). As a result, the atomic ratio of Q_{O}/Q_{C} (wherein Q_{C} represents the total number of carbon atoms constituting the surface of the PP film, and Q_{O} is the number of oxygen functional groups, each partially bonded to a carbon atom) was found 0.13.

Then, tetramethoxy silane (TMOS) was dissolved in methanol to obtain a methanol solution containing 5% by weight of TMOS, to which acetic acid was further added to adjust the pH thereof to 4.5 to 5.5. Thereafter, the plasma-treated OPP film was unwound from the take-up roller and immersed in the methanol solution of TMOS by allowing the plasma-treated OPP film to pass through the methanol solution, the resultant plasma-treated OPP film being subsequently wound around a separate take-up roller. The immersion time of the OPP film in this case was set to 5 minutes. Then, the OPP film taken out of the methanol solution of TMOS was heated for 2 hours in an oven controlled at a temperature of 50°C, thereby accomplishing a coupling reaction between the oxygen functional group of the OPP film and the TMOS. After this coupling reaction, the OPP film was washed with methanol by means of a high-frequency washing machine to remove unreacted TMOS from the surface of the OPP film.

Thereafter, the aforementioned separate take-up roller wound up with this OPP film that was undergone the coupling reaction was set in place as a supply roller inside the chamber 1 as shown in FIGURE, and then as in the case of the aforementioned argon plasma treatment step, the distal end portion of the OPP film was pulled, while being guided by a pair of feed rollers 10 and 11, to pass through a space between a pair of electrodes 3 and 4 so as to be wound around the take-up roller 9. Thereafter, the valve 21 attached to the pipe 19 was opened to allow argon to be fed from the argon gas cylinder 18 via the mass flow controller 17 and the second gas-feeding pipe 22 to the interior of the chamber 1, thereby substituting argon for the air existing inside the chamber 1. At the same time, an exhaust system (not shown) consisting of a rotary pump and a diffusion pump was actuated so as to discharge the gas from the chamber 1 via the exhaust pipe 23, thereby reducing the internal pressure of the chamber 1 to 0.13 Pa.

Then, while continuing the exhausting operation of the exhaust system, the valve 21 was closed and the valve 14 was opened to allow the steam of TMOS to be discharged from the receiver tank 12, thereby feeding the steam of TMOS via the first gas-feeding pipe 13 to a region below the circular electrode (upper electrode) 3 in the chamber 1 at a flow rate of 6 cm³/min. At the same time, the valve 20 attached to the pipe 16 was opened to allow oxygen to be discharged from the oxygen gas cylinder 15, thereby feeding oxygen via the mass flow controller 17 and the second gas-feeding pipe 22 to the space between the electrodes 3 and 4 in the chamber 1 at a flow rate of 9 cm³/min.

Then, while maintaining the pressure inside the chamber 1 to 33.9 Pa, a high-frequency power 13.56 MHz in frequency and 60W in output was fed from the RF power source 6 via the matching box 5 to the rectangular electrode (a lower electrode) 4, thereby allowing a plasma polymerization to take place between the TOMS and oxygen at a region between the electrodes 3 and 4 in the chamber 1.

Upon confirming the stabilization of this plasma polymerization, the take-up roller 9 was rotated so as to unwind the OPP film that had been treated with the silane coupling reaction from the supply roller 8 and to enable the OPP film to pass, while being guided by a pair of feed rollers 10 and 11, through the plasma polymerization region formed between the electrodes 3 and 4 at a running speed of 10 mm/min, thereby depositing an SiOₓ thin film having a thickness of 100 nm on the surface of OPP film to obtain a gas barrier film. Thereafter, the pressure inside the chamber 1 was exhausted to 0.13 Pa over 30 minutes, and then, argon gas was admitted into the chamber 1 so as to increase the pressure inside the chamber 1 up to the atmospheric pressure, after which the take-up roller carrying the OPP film was taken out of the chamber 1.

### (Example 2)

A gas barrier film was manufactured in the same manner as in Example 1 except that a methanol solution containing 7% by weight of TMOS was employed in the silane coupling reaction between the TMOS and the oxygen functional group introduced into the surface of the OPP film.

The gas barrier films obtained in Examples 1 and 2 were found as respectively having a structure wherein the SiOₓ thin film was formed on the surface of the OPP film in such a manner that the SiOₓ thin film was bonded to the tuning molecular chains having, as a main skeleton, an -O-Si-O- structure and introduced via the oxygen (-O-) thereof into the carbon atoms of the surface of OPP film.

### (Comparative Example 1)

A gas barrier film was manufactured by depositing an SiOₓ thin film having a thickness of 100 nm on the OPP film through a plasma polymerization between the TMOS and oxygen under the same conditions as in Example 1 except that the aforementioned argon plasma treatment and silane coupling reaction were not performed on the OPP film whose surface had been washed with acetone in advance.

Then, the oxygen gas transmission velocity of the gas barrier films obtained in Examples 1 and 2 and Comparative Example 1 were measured, the results being shown in Table 1 below. The measurement of this oxygen gas transmission velocity of the gas barrier films was performed using a gas barrier tester (Model OX-TRAN 2/20, trade name; Mocon Co., Ltd.), wherein five test samples were cut out of the each gas barrier film, and attached respectively to the measuring section (78 mm in diameter) of the tester to perform the measurement at a temperature of 30°C and in a relative humidity of 70%. The oxygen gas transmission velocity shown in Table 1 is an average value of these five samples.

By the way, Table 1 also includes the oxygen gas transmission velocity of the 40*µ* thick OPP film itself (Reference Example 1), the oxygen gas transmission velocity of a gas barrier film which was manufactured by depositing an SiOₓ thin film having a thickness of 100 nm directly on a PET film having a thickness of 38 *µ*m through a plasma polymerization between the TMOS and oxygen under the same conditions as in Example 1, which was performed after washing the surface of the PET film with acetone in advance (Reference Example 2), and the oxygen gas transmission velocity of the K-coat film (Reference Example 3).

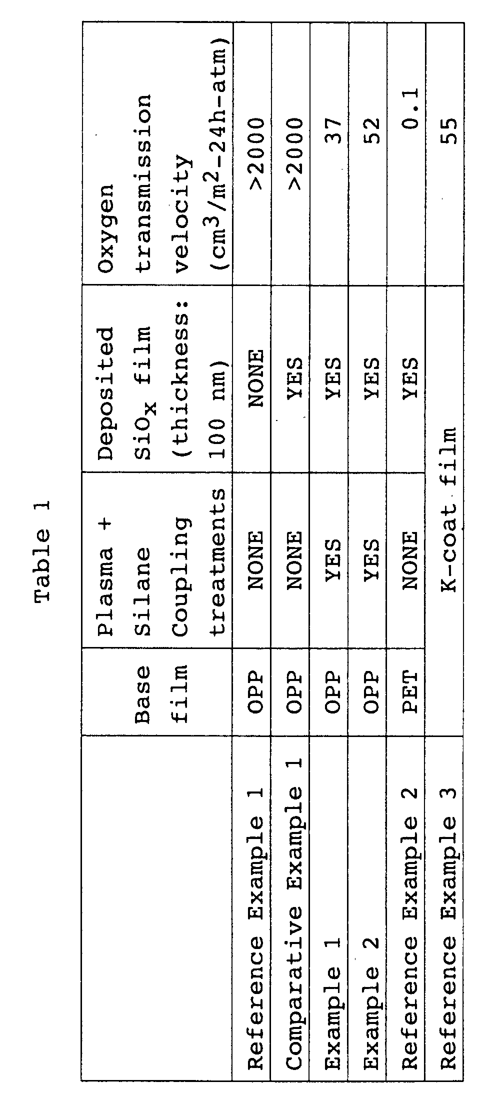

As apparent from Table 1, the gas barrier film of Comparative Example 1 wherein the SiOₓ thin film was directly deposited on the OPP film without performing the argon plasma treatment and silane coupling reaction was found to exhibit almost the same degree of oxygen gas transmission velocity as that of the OPP film per se (Reference Example 1), thus failing to take advantage of the inherent excellent oxygen barrier property of the SiOₓ thin film.

By contrast, the gas barrier films of Examples 1 and 2 wherein the SiOₓ thin film was deposited on the OPP film after subjecting it to the argon plasma treatment and silane coupling reaction were found to exhibit an excellent oxygen gas transmission velocity, i.e. 37 cm³/m²-24h-atom and 52 cm³/m²-24h-atom, respectively, which values were as low as about 1/60 of the gas barrier films of Comparative Example 1. Although the gas barrier films of Examples 1 and 2 were inferior in gas barrier property to the gas barrier film of Reference Example 2 where the SiOₓ thin film was deposited directly on the PET film, the gas barrier films of Examples 1 and 2 were almost comparable in gas barrier property to the K-coat film (Reference Example 3).

As explained above, it is possible according to this invention to provide a gas barrier film having, as a base film, a PP film, which makes it possible to take advantage of the excellent gas barrier property inherent to an SiOₓ thin film formed on the PP film, and which is free from chlorine which would give a bad influence to the environment as in the case of the K-coat film, thereby making the gas barrier film useful as a packing material for various kinds of foodstuffs. It is now possible according to this invention to provide a method which is suited for manufacturing such a gas barrier film.

## Claims

1. A gas barrier film having polypropylene as a base film, which comprises;
a polypropylene film whose surface is bonded with tuning molecular chains having, as a main skeleton, an -O-Si-O- structure by enabling the oxygen (-O-) thereof to be bonded to carbon atoms of the surface of said polypropylene film; and
an SiOₓ thin film formed on the surface of said polypropylene film where said tuning molecular chains are bonded, said SiOₓ thin film being bonded to said tuning molecular chains interposed between said polypropylene film and said SiOₓ thin film.

2. The gas barrier film according to claim 1, **characterized in that** a bond ratio of said tuning molecular chains to a surface of said polypropylene film is in the range of 0.05 to 0.20 as measured based on an atomic ratio between the total number of carbon atoms constituting the surface of the polypropylene film and the number of oxygen atoms, each partially bonded to a carbon atom (i.e. Q_{O}/Q_{C}; wherein Q_{C} represents the total number of carbon atoms constituting the surface of the polypropylene film, and Q_{O} is the number of oxygen functional groups, each partially bonded to a carbon atom).

3. The gas barrier film according to claim 1, **characterized in that** said tuning molecular chains include an alkyl group which is attached to an intermediate or terminal portion of the main skeleton thereof.

4. A method of manufacturing a gas barrier film having polypropylene as a base film, said method comprising the steps of;
activating carbon atoms of a surface of said polypropylene film by subjecting said polypropylene film to a plasma treatment, the activated carbon atoms being subsequently exposed to air atmosphere to allow the activated carbon atoms to be bonded with oxygen, thereby introducing oxygen functional groups into the surface of said polypropylene film;
allowing a coupling reaction to take place between the oxygen functional group of said polypropylene film and a silane coupling agent, thereby bonding tuning molecular chains having, as a main skeleton, an -O-Si-O- structure, to carbon atoms of the surface of said polypropylene film through said oxygen functional group (-O-); and
allowing a plasma polymerization between Si and O in a plasma atmosphere containing an organic silane compound and oxygen, thereby forming an SiOₓ thin film on the surface of said polypropylene film having said tuning molecular chains bonded therein.

5. The method according to claim 4, **characterized in that** said plasma treatment is performed using an argon plasma.

6. The method according to claim 4, **characterized in that** said oxygen functional groups are introduced into carbon atoms of the polypropylene film in the form of C-O and/or C=O.

7. The method according to claim 4, **characterized in that** an introduction ratio of said oxygen functional groups to the polypropylene film is in the range of 0.05 to 0.20 as measured based on an atomic ratio between the total number of carbon atoms constituting the surface of the polypropylene film and the number of oxygen atoms, each partially bonded to a carbon atom (i.e. Q_{O}/Q_{C}; wherein Q_{C} represents the total number of carbon atoms constituting the surface of the polypropylene film, and Q_{O} is the number of oxygen functional groups, each partially bonded to a carbon atom).

8. The method according to claim 4, **characterized in that** said silane coupling agent is an organic silane compound represented by a general formula of: -(R¹O)ₙ-Si-R²(4-n) (wherein R¹ and R² individually represents alkyl group having 1 to 4 carbon atoms).

9. The method according to claim 8, **characterized in that** said coupling reaction is performed by a process wherein the polypropylene film having said oxygen functional group introduced therein is immersed in an alcohol solution of the silane coupling agent, and then, heated the film coated with the alcohol solution.

10. The method according to claim 9, **characterized in that** a concentration of said silane coupling agent in the alcohol solution thereof is in the range of 0.1 to 10% by weight.

11. The method according to claim 9, **characterized in that** said polypropylene film coated with the alcohol solution is heated at a temperature of 50 to 80°C.

12. The method according to claim 4, **characterized in that** said organic silane compound is represented by a general formula of: -(R¹O)ₙ-Si-R²₍₄₋ₙ₎ (wherein R¹ and R² individually represents alkyl group having 1 to 4 carbon atoms).

13. The method according to claim 4 or 12, **characterized in that** said organic silane compound and oxygen are employed by mixing them at a molar ratio of; organic silane compound:oxygen = 3:7 - 5:5.
